# EUROPÄISCHE PATENTSCHRIFT

(11) **EP 1 665 005 B1**
(45) Veröffentlichungstag und Bekanntmachung des Hinweises auf die Patenterteilung: **09.01.2008**
(21) Anmeldenummer: 04786778.3
(22) Anmeldetag: 15.09.2004
(51) Int. Cl.: G06F 1/26, G06F 15/80

(54) **PROZESSOR-ANORDNUNG, TEXTILGEWEBESTRUKTUR, FLÄCHENVERKLEIDUNGSSTRUKTUR UND VERFAHREN ZUM WEITERLEITEN VON ELEKTRISCHER ENERGIEVERSORGUNG ZWISCHEN EINER VIELZAHL EINANDER ÖRTLICH BENACHBART ANGEORDNETER PROZESSORELEMENTE**
PROCESSOR ARRAY, FABRIC STRUCTURE, SURFACE-COVERING STRUCTURE, AND METHOD FOR TRANSMITTING ELECTRICITY AMONG A PLURALITY OF ADJACENT PROCESSOR ELEMENTS
ENSEMBLE PROCESSEUR, STRUCTURE EN TISSU TEXTILE, STRUCTURE D'HABILLAGE DE SURFACES ET PROCEDE DE TRANSMISSION D'ENERGIE ELECTRIQUE ENTRE UNE PLURALITE D'ELEMENTS DE PROCESSEUR ADJACENTS

(30) Priorität: 24.09.2003 DE 10344285
(43) Veröffentlichungstag der Anmeldung: 07.06.2006
(73) Patentinhaber: Infineon Technologies AG, 81669 München (DE)
(72) Erfinder: GLASER, Rupert, 85457 Wörth, OT Hoerlkofen (DE)
(74) Vertreter: Viering, Jentschura & Partner
(86) Internationale Anmeldenummer: PCT/DE2004/002059
(87) Internationale Veröffentlichungsnummer: WO 2005/031550

(56) Entgegenhaltungen:
- WO-A-01/96993
- US-A- 3 631 298
- US-A- 5 814 771
- US-A- 5 941 714
- US-A1- 2002 030 475
- US-A1- 2003 139 823
- US-B1- 6 210 771
- POST E R ET AL: "Smart fabric, or wearable clothing" WEARABLE COMPUTERS, 1997. DIGEST OF PAPERS., FIRST INTERNATIONAL SYMPOSIUM ON CAMBRIDGE, MA, USA 13-14 OCT. 1997, LOS ALAMITOS, CA, USA,IEEE COMPUT. SOC, US, 13. Oktober 1997 (1997-10-13), Seiten 167-168, XP010251560 ISBN: 0-8186-8192-6

## Beschreibung

Die Erfindung betrifft eine Prozessor-Anordnung, eine Textilgewebestruktur, eine Flächenverkleidungsstruktur sowie ein Verfahren zum Weiterleiten von elektrischer Energieversorgung zwischen einer Vielzahl einander örtlich benachbart angeordneter Prozessorelemente.

In [1] ist eine Prozessor-Anordnung beschrieben, welche eine Vielzahl von Prozessorelementen aufweist, wobei jedes Prozessorelement ein bildgebendes Element wie beispielsweise eine Leuchtdiode, einen Speicher, mehrere Daten-Kommunikationsschnittstellen sowie mehrere Energieversorgungs-Schnittstellen aufweist.

Die einzelnen Prozessorelemente sind frei innerhalb der Prozessor-Anordnung örtlich angeordnet und mit ihren jeweils unmittelbar benachbarten Prozessorelementen zum Austausch elektrischer Nachrichten mittels ihrer Daten-Kommunikationsschnittstellen gekoppelt. Die Prozessorelemente sind mit einer gemeinsamen Spannungsquelle verbunden, wobei die Prozessorelemente jeweils mit ihren unmittelbar örtlich benachbarten Prozessorelementen mittels der Energieversorgungs-Schnittstellen miteinander gekoppelt sind.

Somit ist ein Netzwerk aus verteilten Prozessoren bzw. Prozessorelementen in [1] beschrieben, welches aus einer gemeinsamen Spannungsversorgung gespeist wird. Ein solches Netzwerk ist anfällig gegen in dem Netzwerk auftretende elektrische Kurzschlüsse. Ein einziger auftretender elektrischer Kurzschluss im Rahmen der gemeinsamen Spannungsversorgung führt zum Ausfall des gesamten Netzwerks der Prozessorelemente.

Ferner ist in [1] ein Verfahren zur Selbstorganisation der Prozessorelemente beschrieben, d.h. im Wesentlichen zur automatischen Bestimmung der Position der Prozessorelemente innerhalb der Prozessor-Anordnung bezogen auf eine ReferenzPosition. Die Bestimmung der jeweiligen Position erfolgt unter lokalem Austausch elektronischer Nachrichten lediglich zwischen einander unmittelbar benachbart angeordneten Prozessorelementen.

Ein weiteres Problem bei dem in [1] beschriebenen Netzwerk von Prozessorelementen, allgemein jedoch auftretend bei einem beliebigen Netzwerk von Prozessorelementen besteht in der synchronen Ansteuerung der Prozessorelemente zur Ausgabe von Informationen, wenn die Wege von einem Schnittstellen-Prozessor, angeordnet an der Referenzposition, welcher Daten an alle Prozessorelemente der Prozessor-Anordnung einspeist, unterschiedlich lang sind.

Aus [2] ist ein polymorphes Maschennetzwerk bekannt, das ein Netzwerk von Verarbeitungselementen und einen programmgesteuerten Verbindungssteuermechanismus aufweist, um die Verarbeitungselemente programmgesteuert zu gruppieren. Jedes Verarbeitungselement ist über Verbindungen mit Nachbar-Verarbeitungselementen gekoppelt.

Aus [3] ist ein Bussystem zur elektronischen Energieversorgung bekannt, das eine Spannungsversorgungsvorrichtung zum Steuern der Spannungsversorgung an das Bussystem aufweist. Die Spannungsversorgungsvorrichtung prüft, ob der Spannungsausgang einen ausreichend hohen Widerstand aufweist und steuert die Spannungsversorgung des Bussystems dementsprechend.

Aus [4] ist ein Netzwerk von LEDs bekannt, die in Bekleidung angebracht sind und miteinander gekoppelt sind.

Wie im Folgenden noch näher erläutert wird, kann selbst bei fehlerhaften Prozessorelementen innerhalb der Prozessor-Anordnung das Netzwerk der Prozessorelemente zur Darstellung von Zeichen und Zeichensequenzen, beispielsweise von Schrift, Pfeilen etc. noch immer ausreichend funktionierend arbeiten, wobei es jedoch erforderlich ist, dass die fehlerhaften Prozessorelemente im Rahmen der Darstellung der Zeichen und Zeichensequenzen sowie der Übermittlung elektronischer Nachrichten, welche die von den bildgebenden Elementen darzustellenden Informationen enthalten, ausgeblendet werden. Die Routingwege müssen um die fehlerhaften Prozessorelemente herum neu gebildet werden, wobei Routingwege von Routing-Ästen zusammengefasst werden. Bei der Anzeige von Zeichen und Grafiken sind alle in dem Netzwerk von bildgebenden Elementen und damit in dem Netzwerk der Prozessorelemente vorhandenen Bildpunkte innerhalb eines Frames synchron anzusteuern.

Je nach Anzahl der Bildpunkte ergibt sich eine Datenrate "Anzahl der in dem Bild enthaltenen Bildpunkte pro Sekunde".

Diese beiden oben beschriebenen Forderungen führen zu einem sehr großen Bandbreitenbedarf der Datenkanäle zwischen den Prozessorelementen zur Übertragung der elektronischen Nachrichten mit den darzustellenden Zeichen und Grafiken. Wenn einige Prozessorelemente in der Prozessor-Anordnung ausfallen und somit Routingkanäle bzw. Routingwege zusammengelegt werden müssen, so erhöht sich für die zusammengelegten Kanäle die benötigte Datenrate zusätzlich. Es ist daher eine Überdimensionierung der bereitgestellten Datenübertragungsrate erforderlich um die geforderte Bandbreite bereitzustellen.

In [5] ist eine Prozessoranordnung mit einer Vielzahl von Prozessorelementen offenbart, wobei jedes Prozessorelement vorgegebene Eigenschaften und Funktionen aufweist und das Verhalten der Gesamtanordnung von der Anordnung der einzelnen Prozessorelemente abhängt. Die einzelnen Prozessorelemente weisen einen Prozessor und Energieversorgungsschnittstellen auf. Ferner weisen die Prozessorelemente einen Spannungs-Regulierungs-Schaltkreis auf.

In [6] sind ein System und ein Verfahren offenbart zum sequenziellen Anlegen von elektrischer Spannung an eine Mehrzahl von Lastelementen, wodurch Stromspitzen, welche durch gleichzeitiges Hochfahren aller angeschlossenen Lastelemente entstehen, eliminiert werden können.

In [7] ist ein strombegrenzender Schalter offenbart.

In [8] ist eine Struktur offenbart zum Herstellen von Schaltkreis-Verbindungen mittels eines gewebten Stoffs, indem Leitungsmuster zur Aufnahme von jedem externen Modul bereitgestellt werden.

In [9] sind elektrisch leitfähige Garne und Verfahren zum Verbinden von elektrischen Schaltkreisen in Kleidungsstücken offenbart.

In [10] sind elektrisch aktive Textilien sowie daraus hergestellte Artikel offenbart, wobei leitfähige Fasern zum Transport von elektrischer Energie und elektrischen Signalen eingerichtet sind und an elektrische Komponenten angeschlossen sein können, die direkt auf Stoffe aufgelötet sind.

Der Erfindung liegt das Problem zugrunde, selbst bei einem auftretenden elektrischen Kurzschluss innerhalb einer Prozessor-Anordnung mit einer Vielzahl von miteinander gekoppelten Prozessorelementen den Ausfall der gesamten Prozessor-Anordnung zu vermeiden.

Das Problem wird durch die Prozessor-Anordnung, durch die Textilgewebestruktur, durch die Flächenverkleidungsstruktur und durch das Verfahren zum Weiterleiten von elektrischer Energieversorgung zwischen einer Vielzahl einander örtlich benachbart angeordneter Prozessorelemente mit den Merkmalen gemäß den unabhängigen Patentansprüchen gelöst.

Eine Prozessor-Anordnung weist eine Vielzahl von Prozessorelementen auf. Jedes Prozessorelement weist folgende Elemente auf:
- mindestens einen Prozessor,
- eine Mehrzahl von Energieversorgungs-Schnittstellen zum Übertragen von elektrischer Energie von bzw. zu mehreren dem jeweiligen Prozessorelement benachbarten Prozessorelementen,
- eine Mehrzahl von Energieversorgungs-Schaltern, wobei jeder Energieversorgungs-Schnittstelle ein Energieversorgungs-Schalter zugeordnet ist, mit dem wahlweise elektrische Energie an die jeweilige Energieversorgungs-Schnittstelle zuführbar ist oder nicht zuführbar ist,
- mindestens eine Kurzschluss-Prüfeinheit zum Prüfen ob an einer Energieversorgungs-Schnittstelle ein elektrischer Kurzschluss zu einem an dem jeweiligen Prozessor elektrisch angeschlossenen benachbarten Prozessorelement vorliegt,
- eine Steuereinheit, welche derart eingerichtet ist, dass sie für den Fall, dass an der Energieversorgungs-Schnittstelle kein Kurzschluss vorliegt, den jeweiligen Energieversorgungs-Schalter schließt, so dass elektrische Energie an die Energieversorgungs-Schnittstelle zuführbar ist.

Zumindest teilweise sind bei der erfindungsgemäßen Prozessor-Anordnung nur die einander örtlich direkt benachbart angeordneten Prozessorelemente miteinander zum Austausch elektronischer Nachrichten und zum Übertragen elektrischer Energie gekoppelt.

Ferner ist eine Textilgewebestruktur mit einer oben beschriebenen Prozessor-Anordnung vorgesehen, wobei die Prozessoren in der Textilgewebestruktur angeordnet sind. Ferner weist die Textilgewebestruktur elektrisch leitfähige Fäden auf, welche die Prozessoren miteinander koppeln sowie leitfähige Datenübertragungs-Fäden, welche die Prozessoren miteinander koppeln.

Schließlich sind elektrisch nicht-leitfähige Fäden in der Textilgewebestruktur vorgesehen. Die Textilgewebestruktur kann zur Verkleidung einer Fläche, vorzugsweise eines Fußbodens, einer Wand oder einer Decke verwendet werden.

Die Textilgewebestruktur kann in beliebigen textilen Geweben, beispielsweise auch in Vorhängen, textilen Rollos oder Markisen verwendet werden.

Die Textilgewebestruktur weist eine Mehrzahl von Prozessorelementen zur elektronischen Datenverarbeitung auf, welche Mehrzahl von Prozessorelementen über ebenfalls in der Textilgewebestruktur vorgesehene elektrisch leitfähige Fäden mit Strom versorgt werden können und welche die zu verarbeitenden Daten mittels der Datenübertragungs-Fäden zugeführt bekommt oder über diese senden kann.

Die Textilgewebestruktur besitzt durch ihren Aufbau gegenüber dem Stand der Technik insbesondere den Vorteil, dass sie großflächig hergestellt werden kann und einfach in jede gewünschte Form geschnitten werden kann. Somit kann sie jeder beliebigen Fläche, auf der sie verlegt werden soll, angepasst werden. Es ist nicht erforderlich, die einzelnen Prozessorelemente und gegebenenfalls vorgesehene Sensoren und/oder Aktoren nachträglich miteinander zu koppeln, da die Prozessorelemente schon innerhalb der Textilgewebestruktur miteinander gekoppelt sind.

Anders ausgedrückt bedeutet dies, dass eine Mehrzahl von Prozessorelementen in die Textilgewebestruktur zur Verkleidung einer Fläche eingebettet wird.

Vorzugsweise sind die einzelnen Prozessorelemente aufgrund zusätzlich vorgesehener Komponenten in der Lage, mit anderen Prozessorelementen in der Textilgewebestruktur über die Datenübertragungs-Fäden elektronische Nachrichten auszutauschen und somit eine lokale Positionsbestimmung der jeweiligen Prozessorelemente innerhalb der Textilgewebestruktur bzw. bezüglich einer vorgegebenen Referenzposition zu ermöglichen, d.h. eine Selbstorganisation durchzuführen. Erfindungsgemäß erfolgt die Selbstorganisation bevorzugt gemäß den in [1] beschriebenen Verfahren.

Somit wird es ermöglicht, sehr einfach für ein Prozessorelement, dessen Position innerhalb einer Fläche ohne zusätzliche externe Informationen zu bestimmen, auch wenn eine Textilgewebestruktur durch Schneiden in eine vorgegebene Form gebracht wird, wobei durch das Schneiden Prozessorelemente oder Kupplungsleitungen zwischen den einzelnen Prozessorelementen zerstört oder entfernt werden können.

Damit ist es, im Falle einer Selbstorganisation der Prozessorelemente, für den Massenmarkt auf sehr einfache kostengünstige Weise ermöglicht, eine Textilgewebestruktur auszugestalten und zur Verlegung der Textilgewebestruktur diese gemäß einer vorgegebenen gewünschten Form zuzuschneiden und trotz der zusätzlichen in dieser integrierten Elektronik nicht darauf achten zu müssen, an welchen Positionen die Prozessorelemente innerhalb der mit dieser bedeckten Fläche angeordnet sind, damit das jeweilige Prozessorelement innerhalb der Textilgewebestruktur eindeutig adressierbar ist.

Eine Flächenverkleidungsstruktur weist eine Textilgewebestruktur auf, auf welcher eine Flächenverkleidung fixiert ist. Die Fixierung wird vorzugsweise mittels Klebens und/oder Laminierens und/oder Vulkanisierens durchgeführt.

Insbesondere bei Einsatz des in [1] beschriebenen Verfahrens und der in [1] beschriebenen Prozessor-Anordnung wird ausschließlich lokale Information verwendet und es werden elektronische Nachrichten insbesondere zwischen einander unmittelbar benachbart angeordneten Prozessorelementen ausgetauscht.

Aus diesen Grund ist die Vorgehensweise sehr robust gegenüber auftretenden Störungen und Ausfällen einzelner Prozessorelemente oder einzelner Verbindungen zwischen zwei Prozessorelementen, wenn diese Verbindungen zum Beispiel beim Zuschneiden der Textilgewebestruktur auf eine vorgegebene Form zerstört werden.

Bei einem Verfahren zum Weiterleiten elektrischer Energie zwischen einer Vielzahl einander örtlich benachbart angeordneter Prozessorelemente weist jedes Prozessorelement die oben beschriebenen Elemente auf und es wird in dem Verfahren geprüft, ob an einer Energieversorgungs-Schnittstelle eines Prozessorelements ein elektrischer Kurzschluss zu einem mit dem Prozessorelement gekoppelten, d.h. an diesen angeschlossenen benachbarten Prozessorelement vorliegt. Für den Fall, dass an der Energieversorgungs-Schnittstelle kein elektrischer Kurzschluss vorliegt, wird der jeweilige Energieversorgungs-Schalter geschlossen, so dass elektrische Energie an die Energieversorgungs-Schnittstelle zuführbar ist und somit dem an das Prozessorelement angeschlossene, benachbarte Prozessorelement bereitgestellt wird.

Auf diese Weise wird erfindungsgemäß eine elektronische Schaltung und ein entsprechendes Verfahren in einem Prozessorelement einer oben beschriebenen Prozessor-Anordnung bereitgestellt, mittels der bzw. dem ein gesteuerter Aufbau der Energieversorgungs-Wege in kontrollierter Weise bereitgestellt wird, ohne dass die Gefahr besteht, dass ein elektrischer Kurzschluss zwischen zwei Prozessorelementen die gesamte Prozessor-Anordnung zerstört.

Anschaulich werden Bereiche, in denen elektrische Kurzschlüsse auftreten und mittels des oben beschriebenen Verfahrens bzw. der oben beschriebenen Anordnung ermittelt werden, beim Aufbau der Kanäle zur Energieversorgung automatisch ausgeblendet und deaktiviert.

Bevorzugte Ausgestaltungen der Erfindung ergeben sich aus den abhängigen Ansprüchen.

Die im Folgenden beschriebenen Ausgestaltungen der Erfindung betreffen die Prozessor-Anordnung, die Textilgewebestruktur, die Flächenverkleidungsstruktur und das Verfahren zum Weiterleiten elektrischer Energie zwischen einer Vielzahl örtlich benachbart angeordneten Prozessorelementen.

Gemäß einer Ausgestaltung der Erfindung ist es vorgesehen, dass zumindest ein Teil der Prozessorelemente einen Sensor und/oder einen Aktor aufweisen/aufweist die/der mit dem Prozessor gekoppelt sind/ist. In diesem Fall werden Sensordaten und/oder Aktordaten in den elektronischen Nachrichten zwischen den einander benachbart angeordneten Prozessorelementen übertragen.

Gemäß einer Ausgestaltung der Erfindung weist die mindestens eine Kurzschluss-Prüfeinheit eine Strombegrenzungs-Einrichtung auf. Gemäß dieser Ausgestaltung der Erfindung ist eine sichere und einfache Prüfung, ob ein elektrischer Kurzschluss vorliegt, ermöglicht, ohne dass das prüfende Prozessorelement selbst gefährdet ist.

Gemäß einer anderen Ausgestaltung der Erfindung kann jedem Energieversorgungs-Schalter eine Strombegrenzungs-Einrichtung zugeordnet sein, wobei vorzugsweise zumindest ein Teil der Energieversorgungs-Schalter als strombegrenzter Schalter eingerichtet ist. Diese Ausgestaltung der Erfindung ermöglicht eine einfache und kostengünstige Herstellung eines erfindungsgemäßen Prozessorelements und damit der erfindungsgemäßen Prozessor-Anordnung.

Vorzugsweise sind die Prozessorelemente der Prozessor-Anordnung Matrixförmig in Zeilen und Spalten angeordnet.

Ferner weist die Prozessor-Anordnung gemäß einer Ausgestaltung der Erfindung mindestens einen Schnittstellen-Prozessor auf, der eine Nachrichten-Schnittstelle der Prozessor-Anordnung bereitstellt und elektronische Nachrichten in die Prozessor-Anordnung "einschleusen" kann, d.h. elektronische Nachrichten in diese hinein übertragen kann. Damit werden Sensordaten und/oder Aktordaten in den elektronischen Nachrichten von bzw. zu den Schnittstellenprozessor übertragen.

Gemäß einer Ausgestaltung der Erfindung ist es vorgesehen, dass die elektrisch leitfähigen Fäden derart eingerichtet sind, dass sie zur Energieversorgung der Mehrzahl von Prozessorelementen verwendet werden können.

Bei der Textilgewebestruktur können die leitfähigen Daten Übertragungs-Fäden elektrisch leitfähig sein.

In einer anderen Ausgestaltung der Textilgewebestruktur sind die leitfähigen Daten Übertragungs-Fäden optisch leitfähig.

Die Mehrzahl von Prozessorelementen kann in einem regelmäßigen Raster in der Textilgewebestruktur, vorzugsweise in einem regelmäßigen Rechteck oder quadratischen Raster angeordnet sein.

Besonders bevorzugt ist jedes Prozessorelement aus der Mehrzahl der Prozessorelementen mit allen unmittelbar benachbarten Prozessorelementen mittels der leitfähigen Fäden und der leitfähigen Datenübertragungs-Fäden gekoppelt, d.h. bei einem regelmäßigen Rechteckigen Raster mit jeweils vier benachbarten Prozessorelementen.

Vorzugsweise ist ein erfindungsgemäßer Sensor in einem Prozessorelement ausgestaltet als ein Drucksensor, ein Wärmsensor, ein Rauschsensor, ein optischer Sensor oder als ein Geräuschsensor.

In einer Ausgestaltung der Erfindung ist es ferner vorgesehen, dass ein in dem Prozessorelement vorgesehener Aktor ausgestaltet ist als ein bildgegebenes Element, als ein Schallwellen-Erzeugungselement oder als ein Vibrations-Erzeugungselement.

Anders ausgedrückt bedeutet dies, dass ein jeweiliges Prozessorelement mindestens einen darin integrierten Aktor aufweist. Der Aktor ist beispielsweise eine bildgebende Einheit oder eine schallerzeugende Einheit, vorzugsweise eine Flüssigkristall-Anzeigeeinheit oder eine Polymerelektronik-Anzeigeeinheit allgemein jede Art von Anzeigeeinheit, oder ein Lautsprecher, der eine Schallwelle erzeugt, allgemein jedes eine elektromagnetische Welle erzeugendes Element. Ein weiterer möglicher vorgesehener Aktor in einem Prozessorelement ist ein vibrationserzeugendes Element.

Gemäß einer anderen Ausgestaltung der Erfindung ist bei der Prozessor-Anordnung die Mehrzahl von Prozessorelementen derart eingerichtet, dass zum Ermitteln eines jeweiligen Abstands eines ersten Prozessorelements von einer Referenzposition elektronische Nachrichten ausgetauscht werden zwischen dem ersten Prozessorelement und einem zweiten, diesen benachbarten Prozessorelement der Prozessor-Anordnung. Jede elektronische Nachricht enthält eine Abstandsinformation, welche den Abstand eines die Nachricht sendenden Prozessorelements oder eines die Nachricht empfangenden Prozessorelements von der Referenzposition angibt. Ferner ist die Mehrzahl von Prozessorelementen derart eingerichtet, dass aus der Abstandsinformation einer empfangenen Nachricht der eigene Abstand zu der Referenzposition ermittelbar ist und/oder speicherbar ist.

Besonders bevorzugt sind die Prozessorelemente gemäß [1] eingerichtet zur Durchführung einer Selbstorganisation und zum Ermitteln einer Abstandsinformation, mit der der Abstand des jeweiligen Prozessorelements innerhalb der Prozessor-Anordnung zu einer vorgegebenen Referenzposition angegeben wird.

Vorzugsweise ist die Flächenverkleidungsstruktur als Wand-Verkleidungsstruktur oder Fußboden-Verkleidungsstruktur oder Decken-Verkleidungsstruktur ausgebildet.

Die Flächenverkleidungsstruktur kann zumindest über Teilbereiche der Textilgewebestruktur ein gleichförmig mit elektrisch leitfähigen Drähten durchzogenes Textil aufweisen.

Das mit elektrisch leitfähigen Drähten durchzogene Textil kann zur Vermeidung von "Elektrosmog" in der Umgebung von Menschen verwendet werden. Hierdurch kann der "Elektrosmog" abgeschirmt werden. Dabei ist jedoch zu beachten dass gegebenenfalls bestimmte Bereiche, insbesondere Bereiche über Kapazitätssensoren, nicht von der Abschirmung überdeckt werden dürfen.

Die Erfindung eignet sich insbesondere zum Einsatz in folgenden Anwendungsbereichen:
- Hausautomatisierung, insbesondere zur Erhöhung des häuslichen Komforts,
- Alarmanlagen mit Positionsbestimmung und optionaler Gewichtsbestimmung eines Eindringlings,
- einer automatischen Besucherführung auf Messen bei einer Ausstellung oder in einem Museum,
- für ein Leitsystem in einer Notfallsituation, beispielsweise in einem Flugzeug oder in einem Zug, um den Passagieren einen Weg zu einem Notausgang anzuzeigen,
- in Textilbetonkonstruktionen, in welchen Textilgewebestrukturen dazu dienen können, mögliche Schäden zu detektieren und gegebenenfalls einen Nutzer anzuzeigen,
- Informationsgewinnung zur Führung einer Statistik, in welchen Bereichen in einem Geschäft sich Kunden wie lange aufhalten.

Eine erfindungsgemäße Textilgewebestruktur enthält neben einem vorzugsweise aus Kunstfaser (elektrisch nicht-leitfähige Fäden) bestehenden Grundgewebe, leitfähige Fäden, vorzugsweise leitfähige Kett- und Schussfäden, die vorzugsweise aus Metalldrähten, beispielsweise Kupfer, Polymerfilamenten, Carbonfilamenten oder anderen elektrisch leitfähigen Drähten bestehen. Werden Metalldrähte verwendet, wird vorzugsweise eine Beschichtung aus edleren Metallen, beispielsweise Gold oder Silber als Korrosionsschutz bei Feuchtigkeit oder bei möglichem Kontakt zum aggressiven Medium verwendet. Eine andere Möglichkeit besteht darin, Metallfäden durch das Aufbringen eines Isolierlackes, beispielsweise Polyester, Polyamidinimid oder Polyurethan zu isolieren.

Als Datenübertragungs-Fäden können neben elektrisch leitfähigen Fasern auch Lichtwellenleiter aus Kunststoff oder Glas verwendet werden. Das Grundgewebe der Textilgewebestruktur wird vorzugsweise in einer Dicke hergestellt, welche einer Dicke der zu integrierenden Mikroelektronikkomponenten, im Folgenden auch Mikroprozessormodule genannt, beispielsweise Sensoren, Leuchtdioden, und/oder Mikroprozessoren, angepasst ist. Ein Sensor kann beispielsweise ein Drucksensor, ein Wärmesensor, ein Rauschsensor, ein optischer Sensor oder ein Geräuschsensor sein.

Vorzugsweise wird ein Abstand der optisch und/oder elektrisch leitfähigen Fasern so gewählt, dass es zu einem Anschlussraster der zu integrierenden Prozessorelemente passt.

Auch wenn das folgende Ausführungsbeispiel eine Teppich-Anordnung beschreibt, so ist die Erfindung nicht auf einen Teppich beschränkt sondern ist auf jedes zur Flächenbedeckung bzw. Flächenverkleidung geeignete Element, allgemein auf jede Prozessor-Anordnung und jedes Prozessorelement, in dem es gilt, elektrische Kurzschlüsse zu benachbarten Prozessorelementen zu detektieren, anwendbar.

Die erfindungsgemäße Textilgewebestruktur mit integrierter Mikroelektronik und/oder Sensoren und/oder Aktoren beispielsweise Anzeigelämpchen ist für sich voll funktionsfähig und kann unter verschiedenartigen Flächenverkleidungen fixiert werden.

Hierbei sind zum Beispiel nicht-leitende Textilien, Bodenbeläge aus Teppichboden, Parkett, Kunststoff, Gardinen, Rollos, Tapeten, Isoliermatten, Zeltdächer, Verputzschichten, Estrich und Textilbeton zu nennen. Vorzugsweise wird das Fixieren mittels Klebens, Laminierens oder Vulkanisierens durchgeführt.

Gemäß einer alternativen Ausgestaltung der Erfindung ist eine Prozessor-Anordnung vorgesehen,
- mit mindestens einem Schnittstellen-Prozessor, der eine Nachrichtenschnittstelle der Prozessor-Anordnung bereitstellt,
- mit einer Vielzahl von Prozessoren, wobei zumindest teilweise nur die einander örtlich direkt benachbart angeordneten Prozessoren miteinander zum Austausch elektronischer Nachrichten gekoppelt sind,
- bei der jedem Prozessor der Vielzahl von Prozessoren ein Aktor zugeordnet und mit dem jeweiligen Prozessor gekoppelt ist, wobei Aktordaten in den elektronischen Nachrichten von dem Schnittstellen-Prozessor übertragen werden,
- mit mindestens einer Takterzeugungs-Einrichtung zum synchronen Takten der Prozessoren, und
- mit einer Einheit zum Zuordnen eines Zeitdatums zu einer elektronischen Nachricht mit Aktordaten, welche einem Prozessor zum Durchführen einer Aktion zu einem vorgegebenen Zeitpunkt zu übermitteln ist, wobei mit dem Zeitdatum angegeben wird, nach wie vielen Takten die Aktion gemäß den Aktordaten von dem jeweiligen Prozessor durchzuführen ist.

Es ist in diesem Zusammenhang anzumerken, dass eine synchrone Taktung nicht unbedingt erforderlich ist.

Die Prozessor-Anordnung kann einen Prozessorelement-Abstands-Speicher aufweisen, in dem die Abstände der jeweiligen Prozessorelemente von dem Schnittstellen-Prozessor gespeichert sind.

Ferner kann eine Zeitdatums-Ermittlungseinheit, die eingerichtet ist, unter Verwendung der Abstände der jeweiligen Prozessorelemente von dem Schnittstellen-Prozessor zu einer elektronischen Nachricht das erforderliche Zeitdatum zu ermitteln, vorgesehen sein.

Die Prozessoren der Prozessor-Anordnung sind vorzugsweise matrixförmig in Zeilen und Spalten angeordnet.

Die oben beschriebene Prozessor-Anordnung ist gemäß einer Ausgestaltung der Erfindung in einer Textilgewebestruktur enthalten,
- wobei die Prozessoren und/oder Sensoren und/oder Aktoren in der Textilgewebestruktur angeordnet sind,
- wobei die Textilgewebestruktur elektrisch leitfähige Fäden aufweist, welche die Prozessoren miteinander koppeln sowie leitfähige Datenübertragungs-Fäden, welche die Prozessoren miteinander koppeln und elektrisch nicht-leitfähigen Fäden.

Bei der Textilgewebestruktur können die elektrisch leitfähigen Fäden derart eingerichtet sein, dass sie zur Energieversorgung der Mehrzahl von Prozessoren und/oder Sensoren und/oder Aktoren verwendet werden können.

Bevorzugt sind bei der Textilgewebestruktur die leitfähigen Datenübertragungs-Fäden elektrisch leitfähig, bevorzugt optisch leitfähig.

Der Aktor ist bevorzugt als mindestens eines der folgenden Elemente eingerichtet:
- Bildgebendes Element, oder
- Schallwellen-Erzeugungselement, oder
- Vibrations-Erzeugungselement

Bei einer Flächenverkleidungsstruktur ist bevorzugt auf einer Textilgewebestruktur eine Flächenverkleidung fixiert.

Bei einer bevorzugten Flächenverkleidungsstruktur ist die Flächenverkleidung auf der Textilgewebestruktur aufgeklebt und/oder auflaminiert und/oder vulkanisiert.

Eine Flächenverkleidungsstruktur gemäß einer Ausgestaltung der Erfindung ist ausgebildet als:
- Wand-Verkleidungsstruktur, oder
- Fußboden-Verkleidungstruktur, oder
- Decken-Verkleidungstruktur.

Ferner kann bei einer Flächenverkleidungsstruktur zumindest über Teilbereichen der Textilgewebestruktur eine gleichförmig mit elektrisch leitfähigen Drähten durchzogene Textillage aufgebracht sein.

Ausführungsbeispiele der Erfindungen sind in den Figuren dargestellt und werden im Folgenden näher erläutert.

In den Figuren sind gleiche Komponenten mit identischen Bezugszeichen versehen.

Es zeigen
- Figur 1: eine Textilgewebestruktur gemäß der Erfindung, als ein grobmaschiges Gewebe mit leitfähigen Fäden und integrierter Mikroelektronik wobei in der Figur 1 vier Bereiche a), b), c) und d) markiert sind;
- Figur 2: eine Textilgewebestruktur gemäß einem Ausführungsbeispiel der Erfindung, auf welchen Teilbereichen ein dunkler Teppich fixiert ist;
- Figur 3: eine Skizze einer Prozessor-Anordnung gemäß einem Ausführungsbeispiel der Erfindung, welche in der Textilgewebestruktur vorgesehen ist;
- Figur 4: eine Skizze eines Prozessorelements gemäß einem Ausführungsbeispiel der Erfindung;
- Figur 5: eine Skizze einer Prozessor-Anordnung, in der eine Problematik eines Ausfalls eines Prozessorelements dargestellt ist; und
- Figur 6: eine Skizze einer Prozessor-Anordnung gemäß einem Ausführungsbeispiel der Erfindung, in der eine synchronisierte vorgegebene Ansteuerung der Prozessorelemente der Prozessor-Anordnung erläutert ist.

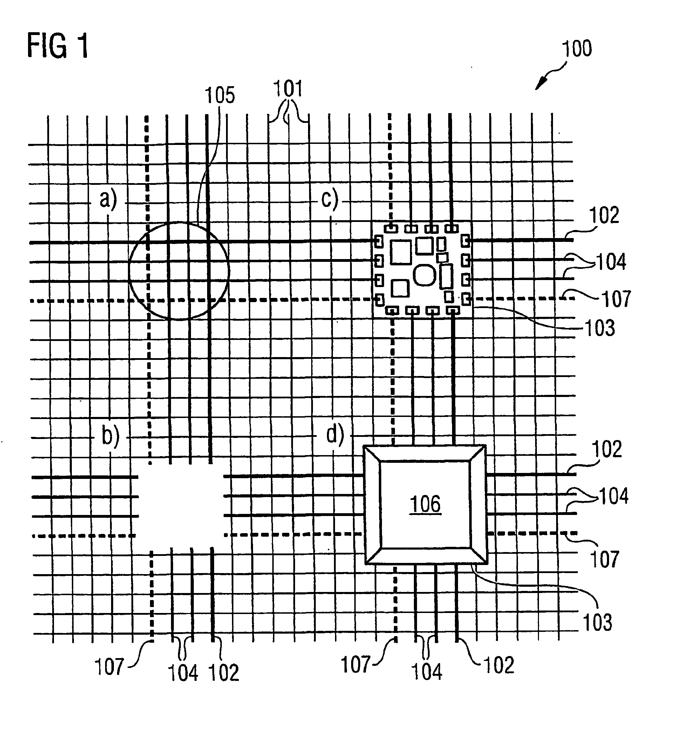

In **Fig.1** ist eine schematische Darstellung einer Prozessor-Anordnung, eingebettet in einer Textilgewebestruktur 100 gemäß einem Ausführungsbeispiel der Erfindung gezeigt.

Die erfindungsgemäße Textilgewebestruktur 100 weist als Grundstruktur ein grobmaschiges Gewebe auf, welches aus nicht-leitfähigen Fäden 101 ausgebildet ist. Ferner weist die Textilgewebestruktur 100 erste elektrisch leitfähige Fäden 102 und zweite elektrisch leitfähige Fäden 107 auf. Die ersten elektrisch leitfähigen Fäden 102 dienen gegebenenfalls als Erdung für in die Textilgewebestruktur 100 zu integrierenden Mikroelektronikkomponenten 103. Die zweiten elektrisch leitfähigen Fäden 107 werden für die Stromversorgung der in die Textilgewebestruktur 100 zu integrierenden Prozessorelemente 103 verwendet.

Ferner weist die Textilgewebestruktur 100 jeweils zwei leitfähige Datenübertragungs-Fäden 104 auf, welche zur Datenübertragung von und zu den integrierten Prozessorelementen 103 verwendet werden.

Die elektrisch leitfähigen Fäden 102, 107 und die leitfähigen Datenübertragungs-Fäden 104 sind vorzugsweise im Gewebe in einem quadratischen Raster angelegt, so dass ein quadratisches Raster von Kreuzungspunkten 105 in der Textilgewebestruktur 100 gebildet wird.

Ein Bereich eines solchen Kreuzungspunktes ist in Fig.1 mit a) markiert.

Ferner sind in einem Bereich, welcher in Fig.1 mit b) markiert ist, eines Kreuzungspunktes 105 die elektrisch leitfähigen Fäden 102, 107 und die leitfähigen Datenübertragungs-Fäden 104 entfernt, wodurch eine Lücke in der Textilgewebestruktur 100 gebildet wird.

Im Bereich c) der Fig.1 ist in einer Lücke in der Textilgewebestruktur 100 ein Prozessorelement 103 angeordnet, wobei die elektrisch leitfähigen Fäden 102, 107 und die leitfähigen Datenübertragungs-Fäden 104 an das Prozessorelement 103 gekoppelt werden, um das Prozessorelement 103 mit elektrischer Energie zu versorgen und eine Datenübertragungsleitung für das Prozessorelement 103 bereitzustellen.

Vorzugsweise wird in der erfindungsgemäßen Textilgewebestruktur 100 jedes Prozessorelement 103 an einem jeweiligen Kreuzungspunkt 105 der elektrisch leitfähigen Fäden 102 und 107 und der leitfähigen Datenübertragungs-Fäden 104 angeordnet und nachfolgend an die elektrisch leitfähigen Fäden 102 und 107 und die leitfähigen Datenübertragungs-Fäden 104 gekoppelt, welche von vier Seiten an das Prozessorelement 103 heranführen.

Die Kopplung zwischen dem Prozessorelement 103 und den elektrisch leitfähigen Fäden 102 und 107 und den leitfähigen Datenübertragungs-Fäden 104 kann mittels Kontaktierung durch eine flexible Leiterplatte oder mittels sogenannten Drahtbondens realisiert sein. Alternativ kann die Kontaktierung mittels Klebens erfolgen.

Im Bereich d) der Fig.1 ist schematisch ein Prozessorelement 103 gezeigt, welches verkapselt ist, um den Kopplungsbereich (Kontaktstellen) zwischen Prozessorelement 103 und den elektrisch leitfähigen Fäden 102, 107 und den leitfähigen Datenübertragungs-Fäden 104 zu isolieren und ferner einen mechanisch robusten und wasserfesten Schutz 106 bereitzustellen.

Eine erfindungsgemäße Textilgewebestruktur 100 weist an einer Mehrzahl von Kreuzungspunkten 105 jeweils ein Prozessorelement 103 auf. Eine solche "intelligente" Textilgewebestruktur 100 kann als Basisschicht oder als Zwischenlage einer Wandverkleidung oder Bodenverkleidung oder andere Arten von technischen Textilien bilden.

Sie kann z.B. auch als Schicht einer Textilbetonkonstruktion verwendet werden. Die Prozessorelemente 103 der Textilgewebestruktur 100 können mit einer Vielzahl von verschiedenartigen Sensoren und/oder Aktoren gekoppelt sein. Zum Beispiel können dies LEDs (Leuchtdioden), Anzeigeelemente oder Displays sein, um Informationen, welche zu den Prozessorelementen 103 übertragen werden anzuzeigen bzw. um erfasste Sensordaten von den Prozessorelementen 103 zu einem Auswertesystem hin über den Schnittstellenprozessor zu übertragen.

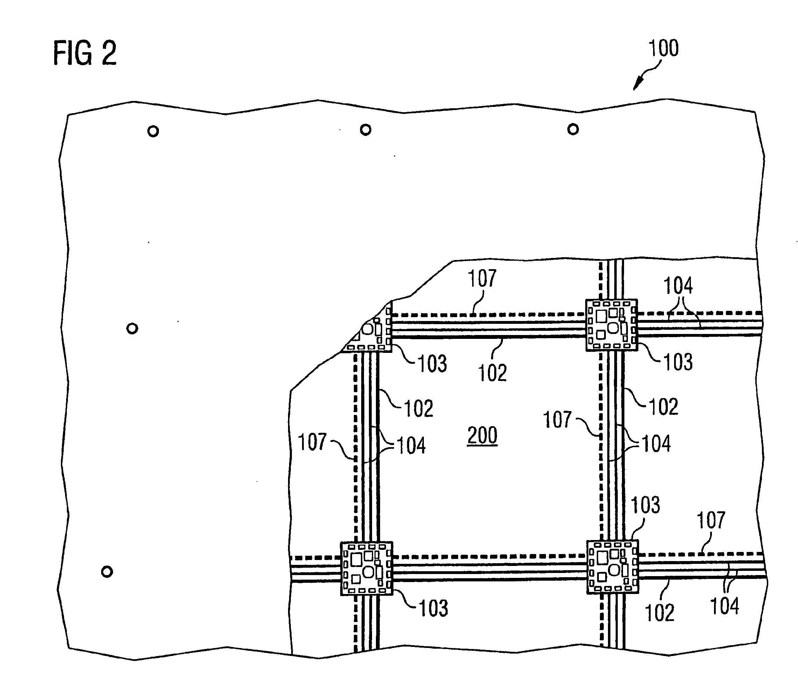

**Fig.2** zeigt ein Ausführungsbeispiel eines so genannten intelligenten Teppichs mit einer erfindungsgemäßen Prozessor-Anordnung.

Im unteren rechten Teil der Fig.2 ist ein grobmaschiges Grundgewebe 200 dargestellt, in welches leitfähige Fäden 102, 104 und 107 in einem quadratischen Raster eingewoben sind. An Kreuzungspunkten 105 der leitfähigen Fäden 102, 104 und 107 sind Prozessorelemente 103 in dem grobmaschigen Grundgewebe 200 angeordnet. Somit entsteht ein regelmäßiges Raster aus Prozessorelementen 103, welche jeweils auf vier Seiten mit Versorgungsleitungen und Datenleitungen kontaktiert sind, wobei die Prozessorelemente 103 zusätzlich mit einer Verkapselung und mit einer Leuchtdiode und/oder mit einem Drucksensor versehen sind.

Ferner ist im linken und hinteren Teil der Fig.2 ein Teppichboden auf der Textilgewebestruktur 100 fixiert.

Die erfindungsgemäße Textilgewebestruktur 100 mit integrierter Mikroelektronik, insbesondere mit integrierten Prozessorelementen 103 mit Sensoren und/oder Aktoren, z.B. Anzeigelämpchen, ist für sich voll funktionsfähig und kann unter verschiedenartige Flächenverkleidungen fixiert werden. Hierbei sind zum Beispiel nicht leitende Textilien, Bodenbeläge aus Teppichboden, Parkett, Kunststoff, Gardinen, Tapeten, Isoliermatten, Zeltdächer, Verputzschichten, Estrich und Textilbeton zu nennen.

Vorzugsweise wird das Fixieren mittels Klebens, Laminierens, oder Vulkanisierens durchgeführt. Zur Vermeidung von "Elektrosmog" in der Umgebung von Menschen, kann über die erfindungsgemäße Textilgewebestruktur zur Abschirmung auch ein gleichförmig mit elektrisch leitfähigen Drähten durchzogenes Textil aufgebracht werden. Dabei ist jedoch zu beachten, dass gegebenenfalls bestimmte Bereiche, z.B. Bereiche über kapazitiven Sensoren, nicht von der Abschirmung überdeckt werden dürfen.

Die erfindungsgemäße Textilgewebestruktur mit integrierter Mikroelektronik wird vorzugsweise an einer Stelle am Rand der Textilgewebestruktur mit einer zentralen Steuereinheit, z.B. einem einfachen Personal Computer, gekoppelt.

Mit einfachen Algorithmen beginnen die Prozessorelemente, sich gemäß den in [1] beschriebenen Verfahren selbst zu organisieren. Wird eine Textilgewebestruktur, welche ein Netzwerk aus Prozessorelementen aufweist, angeschlossen, d.h. in Betrieb genommen, so beginnt eine Lernphase, nach der jedes Prozessorelement seine exakte physikalische Position im Raster kennt.

Ferner werden automatisch Wege für Datenströme durch das Raster hindurch konfiguriert, wodurch Sensorinformationen oder Displayinformationen um defekte Bereiche der Textilgewebestruktur geleitet werden können. Durch die Selbstorganisation des Netzwerkes, werden defekte Bereiche erkannt und umgangen. Dadurch ist das Netzwerk aus Mikroelektronikmodulen auch noch funktionsfähig, falls die Textilgewebestruktur 100 in eine Form geschnitten ist, welche durch den jeweiligen Verwendungszweck vorgegeben ist. Darüber hinaus bewirkt die Selbstorganisation, dass kein manueller Installationsaufwand für das Netzwerk von Mikroelektronikmodulen notwendig ist.

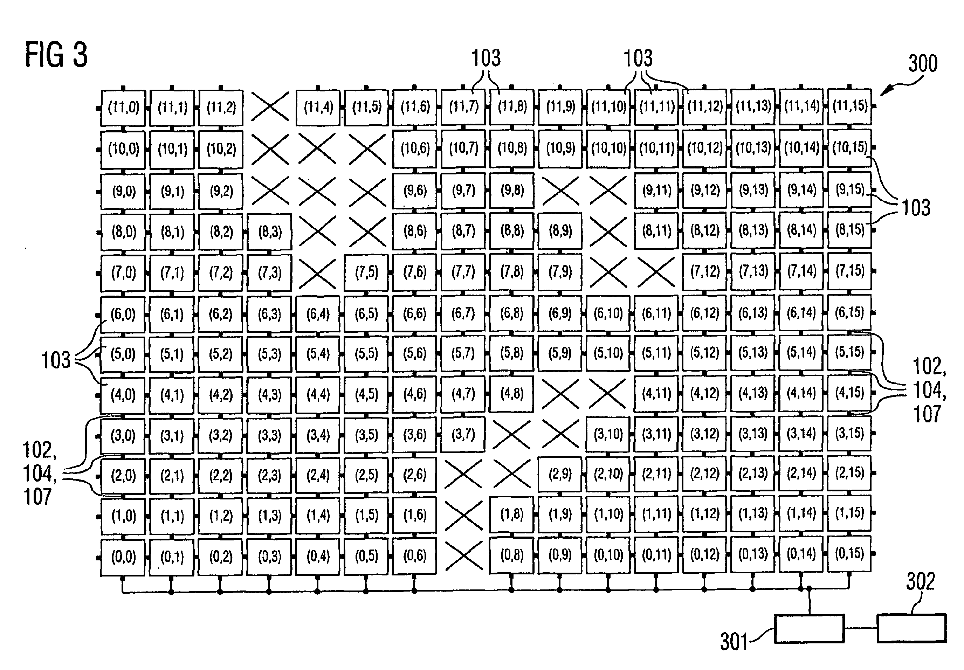

**Fig.3** zeigt eine schematische Draufsicht auf eine Prozessor-Anordnung 300 der Textilgewebestruktur 100 aus Fig.1 und Fig.2 mit einer Vielzahl von Prozessorelementen 103, welche in ein Textilelement, wie oben beschrieben, eingebettet sind.

Die Prozessorelemente 103 sind an jeweils einem Kreuzungspunkt 105 von zwei im Wesentlichen im rechten Winkel zueinander angeordneten Textilfäden eingebracht, wie oben im Zusammenhang mit Fig.1 beschrieben.

Gemäß einer ersten alternativen Ausführungsform ist vorgesehen, dass die Textilfäden selbst elektrisch leitfähig sind. Sind sie es nicht, so ist es in einer anderen Ausgestaltung der Erfindung vorgesehen, wie oben beschrieben, dass in den Textilfäden elektrisch leitfähige Leitungen 102, 104, 107 vorhanden sind zum Übertragen elektrischer Signale.

Mittels der elektrisch leitfähigen Textilfasern oder mittels der elektrischen Leitungen 102, 104, 107 sind die einander unmittelbar benachbarten Prozessorelemente 103 in dem Textilgewebe 100 miteinander zum Austausch elektronischer Nachrichten gekoppelt.

Ferner ist ein als Schnittstellenprozessor 301 vorgesehener Portal-Prozessor bereitgestellt, welcher mit mindestens einem der Prozessorelemente 103 in dem Textilelement 100 verbunden ist zum Einspeisen bzw. Auslesen von Nachrichten in bzw. aus der Prozessor-Anordnung 300. Ferner ist ein mit dem Schnittstellenprozessor 301 gekoppeltes Auswertesystem 302 vorgesehen, eingerichtet als Personal Computer, mit dem eine Auswertung der von den Sensoren der Prozessorelemente 103 erfassten und aus der Prozessor-Anordnung 100 über den Schnittstellenprozessor 101 zu dem Auswertesystem 102 übertragenen Sensordaten durchgeführt wird, beispielsweise eine statistische Überwachung der Daten, eine Schwellenwertüberprüfung, etc.

Die Prozessoren der Prozessorelemente 103 ermitteln in einem Verfahren, wie es in [1] beschrieben ist, im Rahmen einer Selbstorganisation ihre Position relativ zu dem oder den Schnittenstellenprozessoren 102.

Die Prozessoren der Prozessor-Anordnung 100 sind bezüglich des Schnittstellenprozessors 101 in einer Baumstruktur mit unterschiedlichen Hierarchieebenen angeordnet. Unter Hierarchieebene ist in diesem Zusammenhang ein Abstand bezüglich des Nachrichtenflusses, definiert in einer Anzahl von zwischen dem betrachteten Prozessor und dem Portalprozessor liegenden anderen Prozessoren, zu verstehen.

Die Prozessoren der Prozessor-Anordnung 300 sind mittels eines globalen synchronen Taktgebers (nicht gezeigt) synchron getaktet.

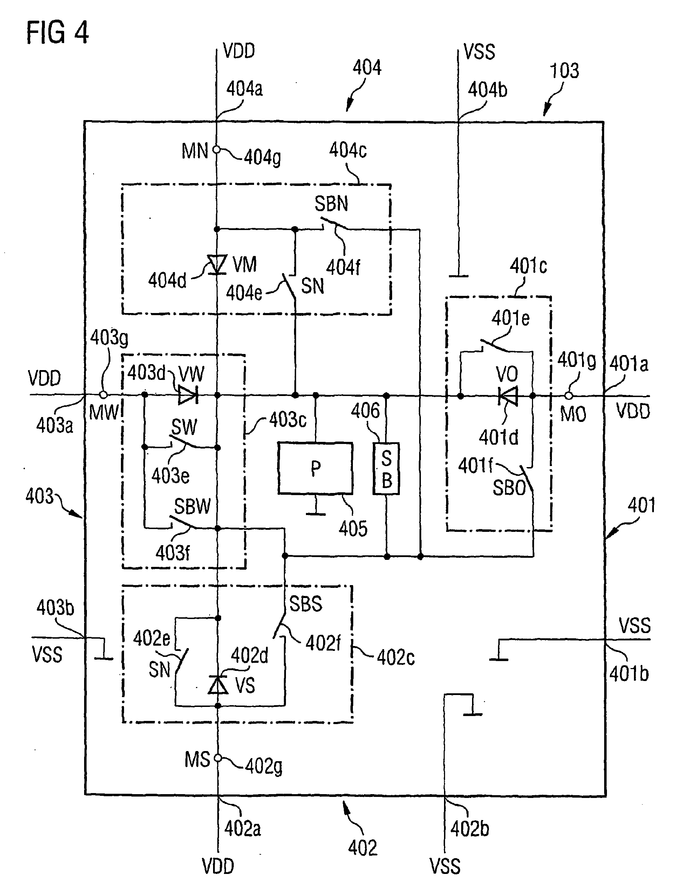

**Fig.4** zeigt den Aufbau des Prozessorelements 103 im Detail.

Wie oben beschrieben weist das Prozessorelement 103 vier Ports, einen ersten Port 401, einen zweiten Port 402, einen dritten Port 403 sowie einen vierten Port 404 auf, wobei jeder Port jeweils einen ersten Betriebspannungs-Anschluss 401a, 402a, 403a, 404a zum jeweiligen Anlegen eines ersten elektrischen Betriebspotentials V_{DD} und einen zweiten Energieversorgungs-Anschluss 401b, 402b, 403b, 404b, vorzugsweise einen Masseanschluss zum Anlegen eines zweiten Betriebspotentials V_{SS}, vorzugsweise zum Bereitstellen eines elektrischen Massepotentials an den jeweiligen Port 401, 402, 403, 404

Jeder erste Energieversorgungs-Anschluss 401a, 402a, 403a, 404a, auch bezeichnet als Betriebsspannungs-Anschluss, des Prozessorelements 103 ist mit einem jeweiligen zugehörigen ersten Energieversorgungs-Anschluss eines mit dem Prozessorelement 103 entsprechend gekoppelten benachbarten Prozessorelements gekoppelt.

Entsprechend ist auch der jeweilige zweite Energieversorgungs-Anschluss 401b, 402b, 403b, 404b mit dem jeweiligen zweiten, zugehörigen Energieversorgungs-Anschluss des unmittelbar örtlich benachbart angeordneten Prozessorelements gekoppelt.

Gemäß dem Ausführungsbeispiel der Erfindung ist der jeweilige zweite Energieversorgungs-Anschluss 401b, 402b, 403b, 404b gemeinsam auf einen Sammelpunkt bzw. auf einem gemeinsamen Ring gelegt. Dioden 401d, 402d, 403d, 404d sorgen aufgrund ihrer entsprechenden Verschaltung dafür, dass der Prozessor 405 mit Spannung versorgt wird, egal aus welchem Port 404, 402, 403, 404 die Betriebsspannung zugeführt wird.

Der erste Betriebsspannungs-Anschluss 401a, 402a, 403a, 404a und der jeweils zugehörige zweite Betriebsspannungs-Anschluss 401b, 402b, 403b, 404b bilden gemeinsam eine jeweilige Energieversorgungs-Schnittstelle des Prozessorelements 103.

In diesem Zusammenhang ist darauf hinzuweisen, dass grundsätzlich eine beliebige Anzahl von Ports und somit eine beliebige Anzahl benachbart angeordneter und mit einem Prozessorelement gekoppelter Prozessorelemente vorgesehen sein kann, so dass die Erfindung nicht auf vier Ports und somit vier benachbarten Prozessorelemente beschränkt ist.

Ferner ist in dem Prozessorelement 103 ein Mikroprozessor 405 vorgesehen sowie eine Strombegrenzungseinheit 406.

Das Prozessorelement 103 weist ferner vier anschaulich als Strom-Ventile und Spannungs-Ventile fungierende Dioden-Anordnungen 401c, 402c, 403c, 404c auf, wobei jede Dioden-Anordnung 401c, 402c, 403c, 404c jeweils einem Port 401, 402, 403, 404 des Prozessorelements 103 zugeordnet ist und ein erster Anschluss der Dioden-Anordnung 401c, 402c, 403c, 404c jeweils mit dem zugehörigen ersten Energieversorgungs-Anschluss 401a, 402a, 403a, 404a gekoppelt ist.

Es ist in diesem Zusammenhang anzumerken, dass zur vereinfachten Darstellung der Erfindung in Fig.4 nur die Leitungen zur elektrischen Energieversorgung dargestellt sind, nicht die ebenfalls in den Prozessorelement 103 vorgesehenen Leitungen zur Übertragung von Daten.

Jede Dioden-Anordnung 401c, 402c, 403c, 404c weist eine Diode 401d, 402d, 403d, 404d auf sowie einen ersten Schalter 401e, 402e, 403e, 404e sowie einen zweiten Schalter 401f, 402f, 403f, 404f.

Der Prozessor 405 ist über die jeweiligen Dioden-Anordnungen 401c, 402c, 403c, 404c bei entsprechender Stellung der jeweiligen Schalter mit dem jeweiligen ersten Energieversorgungs-Anschluss 401a, 402a, 403a, 404a gekoppelt, an welchem das erste Betriebspotential V_{DD} bereitgestellt wird.

Alternativ zu einer jeweiligen Diode 401d, 402d, 403d, 404d kann ein Transistor in Diodenschaltung eingesetzt werden.

In dem Prozessor 405 ist in Form eines Computerprogramms eine Kurzschluss-Prüfeinheit vorgesehen, mit der geprüft wird, ob an einem jeweils zu überprüfenden ersten Energieversorgungs-Anschluss 401a, 402a, 403a, 404a ein elektrischer Kurzschluss zu einem benachbart angeordneten und mit dem jeweiligen elektrischen Energieversorgungs-Anschluss gekoppelten Prozessorelement vorliegt.

Das in dem Prozessor 405 gespeicherte und von diesem ausgeführte Computerprogramm ist derart eingerichtet, dass das folgende Verfahren durchgeführt wird.

In einem iterativen Verfahren, d.h. für alle vier erste Energieversorgungs-Anschlüsse 401a, 402a, 403a, 404a wird folgendes Verfahren sequentiell durchgeführt.

An dem Port 401, 402, 403, 404 wird die Versorgungsspannung V_{DD} und V_{SS} angelegt. Dies bedeutet, dass beginnend bei einem mit den Schnittstellen-Prozessor gekoppelten Prozessorelement das beschriebene Verfahren durchgeführt wird und sukzessive für alle mit dem jeweiligen Prozessorelement gekoppelten Nachbar-Prozessorelementen die Prüfung auf einen Kurzschluss schrittweise von allen funktionsfähigen Prozessorelementen durchgeführt wird.

An dem ausgewählten Port 401, 402, 403, 404 eines der Prozessorelemente 103 wird bei Prüfen auf einen elektrischen Kurzschluss hin somit die Versorgungsspannung eingespeist. Von diesem Prozessorelement aus erfolgt der Aufbau der Energieversorgungswege.

Die Einspeisung der Energieversorgung kann in einer alternativen Ausgestaltung der Erfindung beginnend bei einem beliebigen Prozessorelement der Prozessor-Anordnung vorgenommen werden.

Das erste Prozessorelement 103 steuert den Energieversorgungs-Aufbau zu seinen ihm unmittelbar örtlich benachbart angeordneten und mit ihm gekoppelten, noch nicht mit Energie versorgten drei Nachbar-Prozessorelementen.

Nach Zuführen der Energieversorgung zu dem Prozessorelement hat das Prozessorelement 103 und damit der Prozessor 405 des Prozessorelements 103 nur eine Energieversorgung über denjenigen Port 401, 402, 403, 404, über den die elektrische Energie eingespeist wird und somit liegt nur an dem einen ersten Energieversorgungs-Anschluss 401a, 402a, 403a, 404a die Versorgungsspannung V_{DD}, V_{SS} an, an dem die Versorgungsspannung zugeführt wird.

Erfindungsgemäß wird von dem Prozessor 405 die Versorgungsspannung unter Verwendung der Strombegrenzungseinheit 406 zur Strombegrenzung der ihm zugeführte elektrische Spannung, d.h. das Betriebspotential V_{DD} an einem zweiten Port 401 ,402, 403, 404, an welchem noch keine Betriebsspannung V_{DD} anliegt, angelegt, so dass an dem Port 401, 402, 403, 404 des Prozessorelements 103 ebenfalls das Betriebspotential V_{DD} angelegt wird und darüber dem Nachbar-Prozessorelement zugeführt wird.

Besteht ein elektrischer Kurzschluss in der elektrischen Verbindung zu dem Nachbar-Prozessorelement an diesem Port, so erkennt das der Prozessor 405 und der Prozessor 405 baut die elektrische Energieversorgungs-Kopplung wieder ab und markiert diesen Port als beschädigt bzw. fehlerhaft.

Alternativ kann es vorgesehen sein, dass an den Port 401, 402, 403, 404 des Prozessorelements 103 das Massepotential oder das zweite Betriebspotential V_{SS} angelegt wird, in welchem Fall die Transistoren in den Schaltern als NMOS-Feldeffekttransistoren ausgebildet sind. In diesem Fall sind die jeweilige Diode 401d, 402d, 403d, 404d, die jeweiligen ersten Schalter 401e, 402e, 403e, 404e und die jeweiligen zweiten Schalter 401f, 402f, 403f, 404f in den Versorgungspfad des Massepotentials bzw. des zweiten Betriebspotentials V_{SS} einzufügen.

An einem Messknoten 401g, 402g, 403g, 404g, welcher sich jeweils zwischen dem jeweiligen ersten Energieversorgungs-Anschluss 401a, 402a, 403a, 404a und der jeweiligen Dioden-Anordnung 401c, 402c, 403c, 404c befindet, kann der Prozessor 405 erfindungsgemäß den elektrischen Spannungspegel messen um zu ermitteln, aus welcher Richtung, d.h. von welchem Port 401, 402, 403, 404 das elektrische Betriebspotential V_{DD} zugeführt wird, um den jeweiligen ersten Schalter 401e, 402e, 403e, 404e zu schließen, so dass ein eventuell an der jeweiligen Diode 401d, 402d, 403d, 404d auftretender Spannungsabfall minimiert oder eliminiert wird.

Nach dem Anlegen einer durch die Strombegrenzungseinheit 406 gesicherten Energieversorgung wird sukzessive der jeweilige andere Port 402, 403, 404, wie oben beschrieben, auf einen möglicherweise vorhandenen elektrischen Kurzschluss hin getestet.

Hierzu werden die zweiten Schalter 401f, 402f, 403f, 404f verwendet.

Nach Abschluss dieser Prüfphase, welche auch als Initialisierung des jeweiligen Prozessorelements hinsichtlich der Energieversorgung angesehen werden kann, werden diejenigen ersten Schalter 401e, 402e, 403e, 404e der Dioden-Anordnungen 401c, 402c, 403c, 404c geschlossen, bei denen festgestellt wurde, dass kein elektrischer Kurzschluss zu dem jeweils benachbarten Prozessorelement, d.h. dem jeweiligen Nachbar-Prozessorelement, aufgetreten ist.

In einer alternativen Ausführungsform ist keine zentrale Strombegrenzungseinheit 406 vorgesehen ist, sondern die Strombegrenzungseinheit 406 ist in jeder Dioden-Anordnung 401c, 402c, 403c, 404c realisiert. Besonders bevorzugt ist in diesem Fall der zweite Schalter 401f, 402f, 403f, 404f als strombegrenzter Schalter eingerichtet.

Die Schalter können in beliebiger Weise als Schaltelement realisiert sein, beispielsweise in Form eines Relaiskontakts als ein Feldeffekttransistor, in Form eines geeignet verschalteten Bipolartransistors, etc.

Das oben beschriebene Verfahren wird von jedem Prozessorelement der Prozessor-Anordnung für alle seine mit einem jeweiligen Nachbar-Prozessorelement gekoppelten Ports 401, 402, 403, 404 durchgeführt und getestet.

Damit baut sich anschaulich sukzessive in der Prozessor-Anordnung ein Energieversorgungs-Spannungsnetz selbsttätig und selbstorganisiert auf.

Sind nach erfolgter Prüfung auf elektrische Kurzschlüsse alle Ports 401, 402, 403, 404 des Prozessorelements 103 initialisiert, wartet das Prozessorelement auf weitere Instruktionen, insbesondere zum Übertragen elektronischer Nachrichten bzw. zum Anzeigen von in den elektronischen Nachrichten enthaltener Information mittels der in dem Prozessorelement ebenfalls enthaltenen, nicht dargestellten bildgebenden Elemente.

Nach erfolgtem gesichertem Energieversorgungsaufbau innerhalb der Prozessor-Anordnung erfolgt die in [1] beschriebene Selbstorganisation zur Ermittlung des Abstands der jeweiligen Prozessorelemente zu einer vorgegebenen Referenzposition.

Ist ein elektrischer Kurzschluss an einem Port 401, 402, 403, 404 von dem Prozessor 405 festgestellt worden, so wird der jeweilige Port 401, 402, 403, 404 als fehlerhaft markiert und der jeweilige erste Schalter 401e, 402e, 403e, 404e wird weiterhin offen gehalten, d.h. nicht geschlossen.

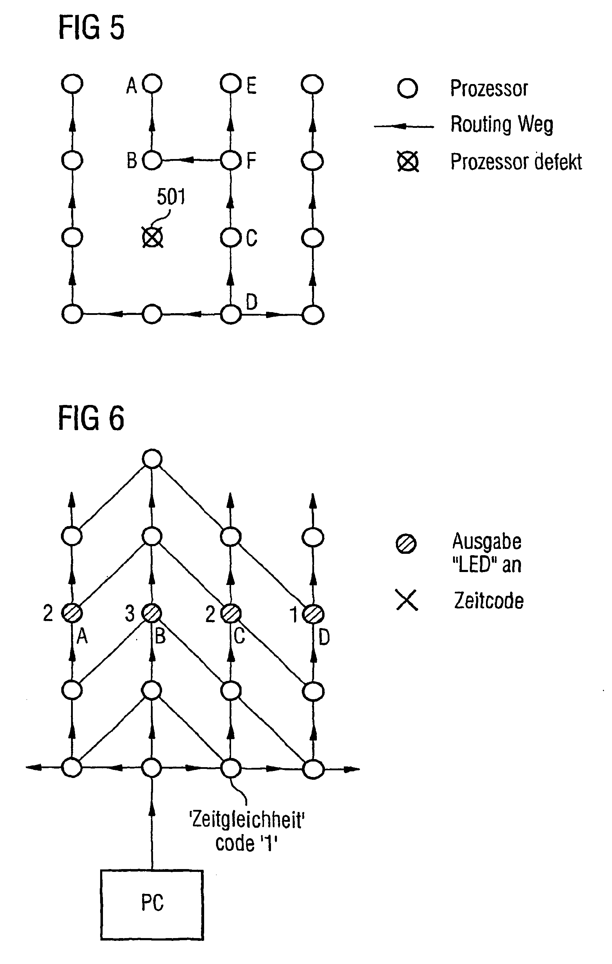

Wie in **Fig.5** dargestellt, ist es bei einem fehlerhaften Prozessorelement erforderlich, dass zur Anzeige von Informationen mittels des bildgebenden Elements jedem Prozessorelement 103 innerhalb der Prozessor-Anordnung die darzustellenden Informationen und Informationen über das Ansteuern seines mindestens einen bildgebenden Elements, beispielsweise einer Leuchtdiode, in einem Speicher des Prozessorelements 103 hinterlegt wird.

Der Schnittstellen-Prozessor, erfindungsgemäß eingerichtet als Personal Computer, errechnet aufgrund des Einspeisepunktes der Daten und der Zeichen, welche von den Prozessorelementen 103 und den darin vorgesehenen bildgebenden Elementen angezeigt werden sollen die Muster, welche in den Prozessorelementen 103 jeweils hinterlegt werden.

Wie in Fig.5 dargestellt ist, müssen bei einem Ausfall eines Prozessorelements (ausgefallenes Prozessorelement ist in Fig.5 mit Bezugszeichen 501 bezeichnet) die Routingwege von Routing-Ästen zusammengefasst werden.

In Fig.5 ist dargestellt, dass die mit A und mit B bezeichneten Prozessorelemente über die mit C und D und F bezeichneten Prozessorelemente mit elektronischen Nachrichten und darüber mit den anzuzeigenden Daten versorgt werden, wobei die Prozessorelemente C, D, F zusätzlich das mit E bezeichnete Prozessorelement mit Daten versorgen müssen.

Allgemein ist in den Fig.5 und Fig.6 ein Prozessorelement einer Prozessor-Anordnung mit einem Kreis symbolisiert dargestellt.

Bei der Anzeige der Daten ist darauf zu achten, dass diese synchron und zeitgleich von den jeweiligen Bildgebenden Elementen der Prozessor-Anordnung dargestellt werden müssen.

Gemäß diesem Ausführungsbeispiel ist zur Gewährleistung der zeitsynchronen Darstellung von Informationen bei Einspeisung der elektronischen Nachrichten durch den Schnittstellenprozessor in die Prozessor-Anordnung vorgesehen, dass vor Einspeisung der elektronischen Nachrichten der Schnittstellenprozessor aufgrund des Einspeisepunktes der elektronischen Nachrichten und der anzuzeigenden Zeichen die Routingwege bzw. die Latenz einer elektronischen Nachricht in der Prozessor-Anordnung zu den jeweiligen Ziel-Prozessorelement, von dessen Bildgebenden Element die jeweilige in der Nachricht enthaltene Information angezeigt werden soll, und die zeitliche Veränderung einer Ausgabe berechnet.

Das Rechenergebnis ist erfindungsgemäß gegeben durch die Ausgabewerte zu einem bestimmten Zeitpunkt, angegeben in Zeittakten, da die Prozessor-Anordnung synchron global getaktet wird und eine elektronische Nachricht jeweils zu einem Zeittakt von einem Prozessorelement zu einem diesen unmittelbar benachbart angeordneten Prozessorelement übertragen wird.

Für alle anzuzeigenden Daten wird für jedes Prozessorelement berechnet, zu welchem Zeitpunkt die Daten in dem jeweiligen Prozessorelement zur Verfügung stehen müssen um die darzustellende Information zur richtigen Zeit einem Benutzer auszugeben. Die Zeitdaten werden für alle Prozessorelemente der Prozessor-Anordnung berechnet und vorab in die Speicher der Prozessorelemente geladen.

Zur Ausgabe der jeweiligen Information sendet der Schnittstellen-Prozessor einen Zeitcode in das Netzwerk, d.h. in die Prozessor-Anordnung. Der Zeitcode wird immer dann weitergegeben, wenn ein neuer Zeitcode eintrifft.

Fig.6 zeigt anhand einer eingezeichneten Linie, wie sich der Zeitcode in der Prozessor-Anordnung verteilt. Durch Verwendung der eingezeichneten Zeitcodes an den Prozessoren A, B, C, D wird erreicht, dass zu einem Zeitpunkt T = 4 die Ausgabe der bildgebenden Elemente der Prozessorelemente A, B, C, D zeitsynchron auf "Leuchtdiode an" gesetzt werden.

Gemäß diesem in Fig.6 dargestellten Ausführungsbeispiel beträgt der Abstand, angegeben in Zeittakten, von dem ersten Prozessorelement A zu dem Schnittstellenprozessor drei Zeittakte, der Abstand des zweiten Prozessorelements B zwei Zeittakte, der Abstand von dem dritten Prozessorelement C drei Zeittakte und der Abstand des vierten Prozessorelements D vier Zeittakte.

Somit muss mindestens vier Zeittakte lang gewartet werden, bis die von den vier Prozessorelementen A, B, C, D zu einem Zeitpunkt darzustellende Information in allen Prozessorelementen verfügbar ist.

Erst nach erfolgter Übertragung der Informationen auch bis in das vierte Prozessorelement D ist es möglich, die gesamte Informationen von allen vier Prozessorelementen A, B, C, D auszugeben.

Um diese zeitsynchrone Darstellung von Informationen zu gewährleisten ist es erforderlich, dass eine kurze Interrupt-Latenzzeit gegenüber der geforderten Framerate, welche ein Zeitintervall von einem ersten darzustellenden Bild zu einem zweiten unmittelbar nachfolgenden Bild bezeichnet, vorausgesetzt wird.

Bei einer Framerate von 20 Bildern pro Sekunden, d.h. einem Frame-Wiederholungsintervall von 50 Millisekunden und einer Prozessor-Anordnung mit maximal 256 x 256 Prozessoren ist somit die Versorgung und zeitgleiche Steuerung und Darstellung von Informationen von allen Prozessoren innerhalb der Prozessor-Anordnung selbst mit handelsüblichen Prozessoren erreichbar.

In diesem Dokument sind folgende Veröffentlichungen zitiert:
[1] DE 101 58 784 A1
[2] DE 37 88 758 T2
[3] DE 196 43 014 C1
[4] US 2003/0100837 A1
[5] US 5,941,714
[6] WO 01/96993 A2
[7] US 2002/0030475 A1
[8] US 3,631,298
[9] E. Rehmi Post, M. Orth, "Smart Fabric, or "Wearable Clothing", Wearable Computers, 1997. Digest of Papers, First International Symposium on Cambridge, MA, USA 13-14 Oct. 1997, Los Alamitos, CA, USA, IEEE Comput. Soc, US, 13. Oktober 1997, Seiten 167-168
[10] US 6,210,771 B1

### Bezugszeichenliste

- 100: Textilgewebestruktur
- 101: nicht-leitfähige Fäden
- 102: erste elektrisch leitfähige Fäden
- 103: Prozessorelement
- 104: leitfähige Datenübertragungs-Fäden
- 105: Kreuzungspunkt
- 106: Schutz
- 107: zweite elektrisch leitfähige Fäden

- 200: Grundgewebe

- 300: Prozessor-Anordnung
- 301: Schnittstellenprozessor
- 302: Auswertesystem

- 401: erster Port
- 402: zweiter Port
- 403: dritter Port
- 404: vierter Port
- 401a: erster Betriebspannungs-Anschluss erster Port
- 401b: zweiter Energieversorgungs-Anschluss erster Port
- 401c: Dioden-Anordnung erster Port
- 401d: Diode erster Port
- 401e: erster Schalter erster Port
- 401f: zweiter Schalter erster Port
- 401g: Messknoten erster Port
- 402a: erster Betriebspannungs-Anschluss zweiter Port
- 402b: zweiter Energieversorgungs-Anschluss zweiter Port
- 402c: Dioden-Anordnung zweiter Port
- 402d: Diode zweiter Port
- 402e: erster Schalter zweiter Port
- 402f: zweiter Schalter zweiter Port
- 402g: Messknoten zweiter Port
- 403a: erster Betriebspannungs-Anschluss dritter Port
- 403b: zweiter Energieversorgungs-Anschluss dritter Port
- 403c: Dioden-Anordnung dritter Port
- 403d: Diode dritter Port
- 403e: erster Schalter dritter Port
- 403f: zweiter Schalter dritter Port
- 403g: Messknoten dritter Port
- 404a: erster Betriebspannungs-Anschluss vierter Port
- 404b: zweiter Energieversorgungs-Anschluss vierter Port
- 404c: Dioden-Anordnung vierter Port
- 404d: Diode vierter Port
- 404e: erster Schalter vierter Port
- 404f: zweiter Schalter vierter Port
- 404g: Messknoten vierter Port
- 405: Prozessor
- 406: Strombegrenzungseinheit

- 501: ausgefallenes Prozessorelement

- A: Prozessorelement
- B: Prozessorelement
- C: Prozessorelement
- D: Prozessorelement
- E: Prozessorelement
- F: Prozessorelement

## Patentansprüche

1. Prozessor-Anordnung,
• mit einer Vielzahl von Prozessorelementen, welche augestattet sind zum gesteuerten Aufbau von Energieversorgungswegen zwischen einander örtlich benachbart angeordneter Prozessorelemente, ausgehend von einem ersten Prozessorelement, wobei jedes Prozessorelement aufweist:
• mindestens einen Prozessor,
• eine Mehrzahl von Energieversorgungs-Schnittstellen zum Übertragen elektrischer Energie von bzw. zu mehreren dem jeweiligen Prozessorelement benachbarten Prozessorelementen,
• eine Mehrzahl von Energieversorgungs-Schaltern, wobei jeder Energieversorgungs-Schnittstelle ein Energieversorgungs-Schalter zugeordnet ist, mit dem wahlweise elektrische Energie an die jeweilige Energieversorgungs-Schnittstelle zuführbar oder nicht zuführbar ist,
• mindestens eine Kurzschluss-Prüfeinheit zum sequenziellen Prüfen, ob an einer Energieversorgungs-Schnittstelle ein elektrischer Kurzschluss zu einem angeschlossenen benachbarten Prozessorelement vorliegt,
• eine Steuereinheit, welche derart eingerichtet ist, dass sie für den Fall, dass an der Energieversorgungs-Schnittstelle kein Kurzschluss vorliegt, den jeweiligen Energieversorgungs-Schalter schließt, so dass elektrische Energie an die Energieversorgungs-Schnittstelle zuführbar ist,
• wobei zumindest teilweise nur die einander örtlich direkt benachbart angeordneten Prozessorelemente miteinander zum Austausch elektronischer Nachrichten und zum Übertragen elektrischer Energie gekoppelt sind.

2. Prozessor-Anordnung gemäß Anspruch 1,
• bei der zumindest ein Teil der Prozessorelemente einen Sensor und/oder einen Aktor aufweisen/aufweist, die/der mit dem Prozessor gekoppelt sind/ist,
• wobei Sensordaten und/oder Aktordaten in den elektronischen Nachrichten zwischen den einander benachbart angeordneten Prozessorelementen übertragen werden.

3. Prozessor-Anordnung gemäß Anspruch 1 oder 2,
bei der die mindestens eine Kurzschluss-Prüfeinheit eine Strombegrenzungs-Einrichtung aufweist.

4. Prozessor-Anordnung gemäß Anspruch 3,
bei der jedem Energieversorgungs-Schalter eine Strombegrenzungs-Einrichtung zugeordnet ist.

5. Prozessor-Anordnung gemäß Anspruch 4,
bei der zumindest ein Teil der Energieversorgungs-Schalter als Strombegrenzter Schalter eingerichtet ist.

6. Prozessor-Anordnung gemäß einem der Ansprüche 1 bis 5, bei der die Prozessorelemente matrixförmig in Zeilen und Spalten angeordnet sind.

7. Prozessor-Anordnung gemäß einem der Ansprüche 1 bis 6, mit mindestens einem Schnittstellen-Prozessor, der eine Nachrichtenschnittstelle der Prozessor-Anordnung bereitstellt,

8. Prozessor-Anordnung gemäß Anspruch 2 und 7,
wobei Sensordaten und/oder Aktordaten in den elektronischen Nachrichten von bzw. zu dem Schnittstellen-Prozessor übertragen werden.

9. Textilgewebestruktur mit einer Prozessor-Anordnung gemäß einem der Ansprüche 1 bis 8,
• bei der die Prozessoren und/oder Sensoren und/oder Aktoren in der Textilgewebestruktur angeordnet sind,
• mit elektrisch leitfähigen Fäden, welche die Prozessoren miteinander koppeln,
• mit leitfähigen Datenübertragungs-Fäden, welche die Prozessoren miteinander koppeln, und
• mit elektrisch nicht-leitfähigen Fäden.

10. Textilgewebestruktur gemäß Anspruch 9,
bei der die elektrisch leitfähigen Fäden derart eingerichtet sind, dass sie zur Energieversorgung der Mehrzahl von Prozessoren und/oder Sensoren und/oder Aktoren verwendet werden können.

11. Textilgewebestruktur gemäß Anspruch 9 oder 10,
bei der die leitfähigen Datenübertragungs-Fäden elektrisch leitfähig sind.

12. Textilgewebestruktur gemäß Anspruch 9 oder 10,
bei der die leitfähigen Datenübertragungs-Fäden optisch leitfähig sind.

13. Textilgewebestruktur gemäß einem der Ansprüche 9 bis 12, bei der der Aktor als mindestens eines der folgenden Elemente eingerichtet ist:
• Bildgebendes Element, oder
• Schallwellen-Erzeugungselement, oder
• Vibrations-Erzeugungselement

14. Flächenverkleidungsstruktur,
bei der auf einer Textilgewebestruktur gemäß einem der Ansprüche 6 bis 10 eine Flächenverkleidung fixiert ist.

15. Flächenverkleidungsstruktur gemäß Anspruch 14,
bei der die Flächenverkleidung auf der Textilgewebestruktur aufgeklebt und/oder, auflaminiert und/oder vulkanisiert ist.

16. Flächenverkleidungsstruktur gemäß Anspruch 14 oder 15, bei der die Flächenverkleidungsstruktur ausgebildet ist als:
• Wand-Verkleidungsstruktur, oder
• Fußboden-Verkleidungstruktur, oder
• Decken-Verkleidungstruktur.

17. Flächenverkleidungsstruktur gemäß einem der Ansprüche 14 bis 16,
bei der zumindest über Teilbereichen der Textilgewebestruktur eine gleichförmig mit elektrisch leitfähigen Drähten durchzogene Textillage aufgebracht ist.

18. Prozessorelement zur Verwendung in einer Prozessor-Anordnung mit einer Vielzahl von Prozessorelementen, welche ausgestattet sind zum gesteuerten Aufbau von Energieversorgungswegen zwischen einander örtlich benachbart angeordneter Prozessorelemente, ausgehend von einem ersten Prozessorelement, mit
• mindestens einem Prozessor,
• einer Mehrzahl von Energieversorgungs-Schnittstellen zum Übertragen elektrischer Energie von bzw. zu mehreren dem jeweiligen Prozessorelement benachbarten Prozessorelementen,
• einer Mehrzahl von Energieversorgungs-Schaltern, wobei jeder Energieversorgungs-Schnittstelle ein Energieversorgungs-Schalter zugeordnet ist, mit dem wahlweise elektrische Energie an die jeweilige Energieversorgungs-Schnittstelle zuführbar oder nicht zuführbar ist,
• mindestens einer Kurzschluss-Prüfeinheit zum sequenziellen Prüfen, ob an einer Energieversorgungs-Schnittstelle ein elektrischer Kurzschluss zu einem angeschlossenen benachbarten Prozessorelement vorliegt,
• einer Steuereinheit, welche derart eingerichtet ist, dass sie für den Fall, dass an der Energieversorgungs-Schnittstelle kein Kurzschluss vorliegt, den jeweiligen Energieversorgungs-Schalter schließt, so dass elektrische Energie an die Energieversorgungs-Schnittstelle zuführbar ist.

19. Verfahren zum gesteuerten Aufbau von Energieversorgungswegen zwischen einer Vielzahl einander örtlich benachbart angeordneter Prozessorelemente, ausgehend von einem ersten Prozessorelement, wobei jedes Prozessorelement aufweist:
• mindestens einen Prozessor,
• eine Mehrzahl von Energieversorgungs-Schnittstellen zum Übertragen elektrischer Energie von bzw. zu mehreren dem jeweiligen Prozessorelement benachbarten Prozessorelementen,
• eine Mehrzahl von Energieversorgungs-Schaltern, wobei jeder Energieversorgungs-Schnittstellen ein Energieversorgungs-Schalter zugeordnet ist, mit dem wahlweise elektrische Energie an die jeweilige Energieversorgungs-Schnittstelle zuführbar oder nicht zuführbar ist,
• wobei zumindest teilweise nur die einander örtlich direkt benachbart angeordneten Prozessorelemente miteinander zum Austausch elektronischer Nachrichten und zum Übertragen elektrischer Energie gekoppelt sind, wobei Sensordaten und/oder Aktordaten in den elektronischen Nachrichten zwischen den Prozessorelementen übertragen werden,
- wobei in dem Verfahren sequenziell geprüft wird, ob an einer Energieversorgungs-Schnittstelle ein elektrischer Kurzschluss zu einem angeschlossenen benachbarten Prozessorelement vorliegt, und
- wobei für den Fall, dass an der Energieversorgungs-Schnittstelle kein Kurzschluss vorliegt, der jeweilige Energieversorgungs-Schalter geschlossen wird, so dass elektrische Energie an die Energieversorgungs-Schnittstelle zuführbar ist.

## Claims

1. A processor array
• having a multiplicity of processor elements, which are provided for controlled set up of power supply channels between processor elements locally adjacent to one another, emanating from a first processor element, each processor element comprising:
• at least one processor,
• a plurality of power supply interfaces for transmitting electricity from and to a plurality of processor elements adjacent to the respective processor element,
• a plurality of power supply switches, each power supply interface being assigned a power supply switch, with which electricity can be supplied or not supplied to the respective power supply interface as desired,
• at least one short-circuit testing unit for sequentially testing whether there is an electrical short-circuit at a power supply interface to a coupled adjacent processor element,
• a control unit, which is set up in such a way that, for the case in which there is no short-circuit on the power supply interface, the respective power supply switch closes, so that electricity can be supplied to the power supply interface,
• at least to some extent, only the processor elements which are arranged locally directly adjacent to one another being coupled to one another in order to exchange electronic messages and to transmit electricity.

2. The processor array as claimed in claim 1,
• in which at least some of the processor elements have a sensor and/or an actuator, which is/are coupled to the processor,
• sensor data and/or actuator data being transmitted in the electronic messages between the processor elements arranged adjacent to one another.

3. The processor array as claimed in claim 1 or 2, in which the at least one short-circuit testing unit has a current limiting device.

4. The processor array as claimed in claim 3, in which each power supply switch is assigned a current limiting device.

5. The processor array as claimed in claim 4, in which at least a portion of the power supply switches is set up as current-limited switches.

6. The processor array as claimed in one of claims 1 to 5, in which the processor elements are arranged in matrix form in rows and columns.

7. The processor array as claimed in one of claims 1 to 6, having at least one interface processor which provides a message interface of the processor array.

8. The processor array as claimed in claim 2 and 7, sensor data and/or actuator data being transmitted in the electronic messages from and to the interface processor.

9. A fabric structure having a processor array as claimed in one of claims 1 to 8,
• in which the processors and/or sensors and/or actuators are arranged in the fabric structure,
• having electrically conductive filaments which couple the processors to one another,
• having conductive data transmission filaments which couple the processors to one another, and
• having electrically nonconductive filaments.

10. The fabric structure as claimed in claim 9, in which the electrically conductive filaments are set up in such a way that they can be used for the power supply to the plurality of processors and/or sensors and/or actuators.

11. The fabric structure as claimed in claim 9 or 10, in which the conductive data transmission filaments are electrically conductive.

12. The fabric structure as claimed in claim 9 or 10, in which the conductive data transmission filaments are optically conductive.

13. The fabric structure as claimed in one of claims 9 to 12, in which the actuator is set up as at least one of the following elements:
• an image-generating element or
• a sound wave generating element or
• a vibration-generating element.

14. A surface-covering structure, in which a surface covering is fixed on a fabric structure as claimed in one of claims 6 to 10.

15. The surface-covering structure as claimed in claim 14, in which the surface covering is adhesively bonded and/or laminated and/or vulcanized on the fabric structure.

16. The surface-covering structure as claimed in claim 14 or 15, in which the surface-covering structure is formed as:
• a wall-covering structure or
• a floor-covering structure or
• a ceiling-covering structure.

17. The surface-covering structure as claimed in one of claims 14 to 16, in which a textile layer interspersed uniformly with electrically conductive wires is applied at least over subregions of the fabric structure.

18. A processor element for use in a processor array having a multiplicity of processor elements, which are provided for controlled set up of power supply channels between processor elements locally adjacent to one another, emanating from a first processor element, comprising
• at least one processor,
• a plurality of power supply interfaces for transmitting electricity from and to a plurality of processor elements adjacent to the respective processor element,
• a plurality of power supply switches, each power supply interface being assigned a power supply switch, with which electricity can be supplied or not supplied to the respective power supply interface as desired,
• at least one short-circuit testing unit for sequentially testing whether there is an electrical short-circuit at a power supply interface to a coupled adjacent processor element,
• a control unit, which is set up in such a way that, for the case in which there is no short-circuit on the power supply interface, the respective power supply switch closes, so that electricity can be supplied to the power supply interface.

19. A method for controlled set up of power supply channels between a multiplicity of processor elements arranged locally adjacent to one another, emanating from a first processor element, each processor element comprising:
• at least one processor,
• a plurality of power supply interfaces for transmitting electricity from and to a plurality of processor elements adjacent to the respective processor element,
• a plurality of power supply switches, each power supply interface being assigned a power supply switch, with which electricity can be supplied or not supplied to the respective power supply interface as desired,
• at least to some extent, only the processor elements arranged locally directly adjacent to one another being coupled to one another to exchange electronic messages and to transmit electricity, sensor data and/or actuator data being transmitted in electronic messages between the processor elements,
- in the method, a sequential check being made at a power supply interface as to whether there is an electric short-circuit to coupled adjacent processor element, and
- for the case in which there is no short-circuit at the power supply interface, the respective power supply switch being closed, so that electricity can be supplied to the power supply interface.

## Revendications

1. Agencement de processeurs comportant
- au moins une pluralité d'éléments à processeurs qui sont destinés à établir de façon commandée des chemins d'alimentation en énergie entre des éléments à processeurs disposés localement à proximité l'un de l'autre, chaque élément à processeurs comportant :
- au moins un processeur,
- une pluralité d'interfaces d'alimentation en énergie permettant de transférer de l'énergie électrique depuis respectivement vers plusieurs éléments à processeurs voisins de l'élément à processeurs respectif,
- une pluralité d'interrupteurs d'alimentation en énergie, chaque interface d'alimentation en énergie étant associée à un interrupteur d'alimentation en énergie, au moyen duquel de l'énergie électrique peut, au choix, être apportée à l'interface d'alimentation en énergie respective ou ne pas l'être,
- au moins une unité de test de court-circuit permettant de tester séquentiellement s'il y a, au niveau d'une interface d'alimentation en énergie, un court-circuit électrique avec un élément à processeurs raccordé voisin,
- une unité de commande, qui est conçue de façon à fermer l'interrupteur d'alimentation en énergie respectif en l'absence de court-circuit au niveau de l'interface d'alimentation en énergie de sorte que de l'énergie électrique peut être apportée à l'interface d'alimentation en énergie,
- au moins en partie seuls les éléments à processeurs, disposés localement à proximité immédiate l'un de l'autre, étant couplés l'un à l'autre afin d'échanger des informations électroniques et de transférer de l'énergie électrique.

2. Agencement de processeurs selon la revendication 1, dans lequel
- au moins une partie des éléments à processeurs comporte un capteur et/ou un actionneur qui sont couplés aux processeurs,
- des données de capteur et/ou des données d'actionneur étant transmises dans les informations électroniques entre les éléments à processeurs voisins l'un de l'autre.

3. Agencement de processeurs selon la revendication 1 ou 2, dans lequel l'au moins une unité de test de court-circuit comporte un dispositif de limitation de courant.

4. Agencement de processeurs selon la revendication 3, dans lequel un dispositif de limitation de courant est associé à chaque interrupteur d'alimentation en énergie.

5. Agencement de processeurs selon la revendication 4, dans lequel au moins une partie des interrupteurs d'alimentation en énergie est conformée en interrupteur limité en courant.

6. Agencement de processeurs selon l'une des revendications 1 à 5, dans lequel les éléments à processeurs sont disposés sous formes matricielles en lignes et colonnes.

7. Agencement de processeurs selon l'une des revendications 1 à 6, comportant au moins un processeur d'interface qui fournit une interface d'information à l'agencement de processeurs.

8. Agencement de processeurs selon les revendications 2 et 7, dans lequel des données de capteur et/ou des données d'actionneur sont transmises dans les informations électroniques depuis respectivement vers le processeur d'interface.

9. Structure tissulaire textile comportant un agencement de processeurs selon l'une des revendications 1 à 8, dans laquelle
- les processeurs et/ou les capteurs et/ou les actionneurs sont disposés dans la structure tissulaire textile qui comporte,
- des fils électriquement conducteurs, qui couplent les processeurs entre eux,
- des fils de transmission de données conducteurs, qui couplent les processeurs entre eux, et
- des fils électriquement non conducteurs.

10. Structure tissulaire textile selon la revendication 9, dans laquelle les fils électriquement conducteurs sont conçus de façon à pouvoir être utilisés pour alimenter en énergie la pluralité de processeurs et/ou de capteurs et/ou d'actionneurs.

11. Structure tissulaire textile selon la revendication 9 ou 10, dans laquelle les fils de transmission de données conducteurs sont électriquement conducteurs.

12. Structure tissulaire textile selon la revendication 9 ou 10, dans laquelle les fils de transmission de données conducteurs sont optiquement conducteurs.

13. Structure tissulaire textile selon l'une des revendications 9 à 12, dans laquelle l'actionneur est conformé en au moins un des éléments suivants :
- un élément de formation d'image, ou
- un élément de production d'ondes sonores, ou
- un élément de production de vibrations.

14. Structure de revêtement de surface, dans laquelle un revêtement de surface est fixé sur la structure tissulaire textile selon l'une des revendications 6 à 10.

15. Structure de revêtement de surface selon la revendication 14, dans laquelle le revêtement de surface est collé et/ou laminé et/ou vulcanisé sur la structure tissulaire textile.

16. Structure de revêtement de surface selon la revendication 14 ou 15, dans laquelle la structure de revêtement de surface est conformée en :
- structure de revêtement mural, ou
- structure de revêtement de plancher, ou
- structure de revêtement de plafond.

17. Structure de revêtement de surface selon l'une des revendications 14 à 16, dans laquelle une couche textile, traversée uniformément de fils électriquement conducteurs, est appliquée au moins sur des régions partielles de la structure tissulaire textile.

18. Elément à processeurs destiné à être utilisé dans un agencement de processeurs comportant une pluralité d'éléments à processeurs qui sont destinés à établir de façon commandée des chemins d'alimentation en énergie entre des éléments à processeurs voisins localement l'un de l'autre, en partant d'un premier élément à processeurs, l'élément à processeurs comportant
- au moins un processeur,
- une pluralité d'interfaces d'alimentation en énergie permettant de transférer de l'énergie électrique depuis respectivement vers plusieurs éléments à processeurs voisins de l'élément à processeurs respectif,
- une pluralité d'interrupteurs d'alimentation en énergie, chaque interface d'alimentation en énergie étant associée à un interrupteur d'alimentation en énergie, au moyen duquel de l'énergie électrique peut, au choix, être apportée à l'interface d'alimentation en énergie respective ou ne pas l'être,
- au moins une unité de test de court-circuit permettant de tester séquentiellement s'il y a, au niveau d'une interface d'alimentation en énergie, un court-circuit électrique avec un élément à processeurs raccordé, voisin,
- une unité de commande, qui est conçue de façon à fermer l'interrupteur d'alimentation en énergie respectif en l'absence de court-circuit au niveau de l'interface d'alimentation en énergie de sorte que de l'énergie électrique peut être apportée à l'interface d'alimentation en énergie.

19. Procédé d'établissement commandé de chemins d'alimentation en énergie entre une pluralité d'éléments à processeurs voisins localement l'un de l'autre en partant d'un premier élément à processeurs, chaque élément à processeurs comportant :
* au moins un processeur,
* une pluralité d'interfaces d'alimentation en énergie permettant de transférer de l'énergie électrique depuis respectivement vers plusieurs éléments à processeurs voisins de l'élément à processeurs respectif,
* une pluralité d'interrupteurs d'alimentation en énergie, chaque interface d'alimentation en énergie étant associée à un interrupteur d'alimentation en énergie, au moyen duquel de l'énergie électrique peut ou ne peut pas, au choix, être apportée à l'interface d'alimentation en énergie respective,
* au moins en partie seuls les éléments à processeurs, immédiatement voisins localement l'un de l'autre, étant couplés l'un à l'autre afin d'échanger des informations électroniques et de transférer de l'énergie électrique, des données de capteur et/ou des données d'actionneur étant transmises dans les informations électroniques entre les éléments à processeurs.
- dans le procédé, un test séquentiel étant effectué pour tester s'il y a, au niveau d'une interface d'alimentation en énergie, un court-circuit électrique avec un élément à processeurs raccordé voisin, et
- en l'absence de court-circuit au niveau de l'interface d'alimentation en énergie, l'interrupteur d'alimentation en énergie respectif étant fermé de sorte que de l'énergie électrique peut être apportée à l'interface d'alimentation en énergie.
